# EUROPÄISCHE PATENTSCHRIFT

(11) **EP 2 457 296 B1**
(45) Veröffentlichungstag und Bekanntmachung des Hinweises auf die Patenterteilung: **06.11.2019**
(21) Anmeldenummer: 10735290.8
(22) Anmeldetag: 22.07.2010
(51) Int. Cl.: B82Y 20/00, H01S 5/30, H01S 5/32, H01S 5/34, H01S 5/347, H01L 33/06, H01L 33/32, H01S 5/343

(54) **OPTOELEKTRONISCHER HALBLEITERKÖRPER MIT EINER QUANTENTOPFSTRUKTUR**
OPTOELECTRONIC SEMICONDUCTOR BODY WITH A QUANTUM WELL
CORPS SEMI-CONDUCTEUR AVEC UNE STRUCTURE A PUITS QUANTIQUES

(30) Priorität: 24.07.2009 DE 102009034588; 07.09.2009 DE 102009040438
(43) Veröffentlichungstag der Anmeldung: 30.05.2012
(73) Patentinhaber: OSRAM Opto Semiconductors GmbH, 93055 Regensburg (DE)
(72) Erfinder: PETER, Matthias, 93055 Regensburg (DE); BUTENDEICH, Rainer, 93059 Regensburg (DE); TAKI, Tetsuya, Yokohama, 223-0057 (JP); OFF, Jürgen, 93059 Regensburg (DE); WALTER, Alexander, 93164 Laaber (DE); MEYER, Tobias, 93346 Ihrlerstein (DE)
(74) Vertreter: Epping - Hermann - Fischer
(86) Internationale Anmeldenummer: PCT/EP2010/060658
(87) Internationale Veröffentlichungsnummer: WO 2011/009923

(56) Entgegenhaltungen:
- DE-A1-102007 044 439
- US-A- 5 496 767
- US-A1- 2006 081 831
- US-A1- 2007 057 337
- US-B1- 6 319 742

## Beschreibung

Die vorliegende Anmeldung betrifft einen optoelektronischen Halbleiterkörper mit einer Quantentopfstruktur.

Optoelektronische Halbleiterkörper mit einer Quantentopfstruktur sind beispielsweise aus den Druckschriften US 2007/057337 A1, US 2006/081831 A1 und DE 10 2007 044 439 A1 bekannt.

Es ist eine Aufgabe der vorliegenden Anmeldung, einen optoelektronischen Halbleiterkörper anzugeben, der eine besonders geringe Vorwärtsspannung hat.

Diese Aufgabe wird durch einen optoelektronischen Halbleiterkörper gemäß den unabhängigen Patentansprüchen gelöst. Vorteilhafte Ausgestaltungen und Weiterbildungen des Halbleiterkörpers sind in den abhängigen Ansprüchen angegeben. Der Offenbarungsgehalt der Patentansprüche wird hiermit ausdrücklich durch Rückbezug in die Beschreibung mit aufgenommen.

Es wird ein optoelektronischer Halbleiterkörper angegeben. Beispielsweise handelt es sich bei dem optoelektronischen Halbleiterkörper um eine Leuchtdiode oder um eine Laserdiode. Der Halbleiterkörper weist eine n-leitende Schicht und eine p-leitende Schicht auf, zwischen denen eine Quantentopfstruktur angeordnet ist. Die Quantentopfstruktur ist zweckmäßigerweise zur Strahlungserzeugung und/oder zum Empfang von elektromagnetischer Strahlung vorgesehen, insbesondere im ultravioletten, sichtbaren und/oder infraroten Spektralbereich.

Bei der Quantentopfstruktur handelt es sich um eine Einfachquantentopfstruktur oder um eine Mehrfachquantentopfstruktur. Die Einfachquantentopfstruktur besteht insbesondere aus folgenden Elementen: einer einzelnen Quantentopfschicht, einer n-seitigen Abschlussschicht und einer p-seitigen Abschlussschicht. Die Mehrfachquantentopfstruktur besteht insbesondere aus folgenden Elementen: einem Schichtstapel, der aus einer Mehrzahl von Quantentopfschichten und mindestens einer Barriereschicht besteht, einer n-seitigen Abschlussschicht und einer p-seitigen Abschlussschicht.

Bei dem Schichtstapel ist zwischen jeweils zwei aufeinander folgenden Quantentopfschichten eine Barriereschicht angeordnet, die an beide Quantentopfschichten angrenzt. Anders ausgedrückt stellt der Schichtstapel eine alternierende Folge von Quantentopfschichten und Barriereschichten dar, wobei der Stapel auf beiden Seiten von einer Quantentopfschicht abgeschlossen ist. Der Schichtstapel enthält somit n-Quantentopfschichten und n-1 Barriereschichten, wobei n eine natürliche Zahl größer oder gleich 2 ist. Bei einer Weiterbildung ist die Anzahl n der Quantentopfschichten kleiner oder gleich 10.

Die jeweiligen Barriereschichten haben insbesondere eine einheitliche Materialzusammensetzung. Anders ausgedrückt bleibt die Materialzusammensetzung der jeweiligen Barriereschichten im Verlauf von einer der angrenzenden Quantentopfschichten zur anderen angrenzenden Quantentopfschicht insbesondere unverändert. Eine Barriereschicht mit einheitlicher Materialzusammensetzung enthält insbesondere keine Folge von Abschnitten unterschiedlicher Materialzusammensetzung.

Weist der Halbleiterkörper eine Mehrfachquantentopfstruktur auf, grenzt die n-seitige Abschlussschicht an den Schichtstapel und die n-leitende Schicht an. Die p-seitige Abschlussschicht ist zwischen dem Schichtstapel und der p-leitenden Schicht angeordnet und grenzt an den Schichtstapel an. Vorzugsweise grenzt die p-seitige Abschlussschicht auch an die p-leitende Schicht an.

Anders ausgedrückt ist bei einem Halbleiterkörper mit einer Mehrfachquantentopfstruktur der Schichtstapel zwischen der n-seitigen Abschlussschicht und der p-seitigen Abschlussschicht derart angeordnet, dass in Richtung von der n-Seite des Halbleiterkörpers her gesehen die n-seitige Abschlussschicht an die erste Quantentopfschicht des Schichtstapels angrenzt und die p-seitige Abschlussschicht an die letzte Quantentopfschicht des Schichtstapels angrenzt.

Weist der Halbleiterkörper eine Einfachquantentopfstruktur auf, grenzt die n-seitige Abschlussschicht an die einzelne Quantentopfschicht und die n-leitende Schicht an. Die p-seitige Abschlussschicht ist zwischen der einzelnen Quantentopfschicht und der p-leitenden Schicht angeordnet und grenzt an die einzelne Quantentopfschicht an. Vorzugsweise grenzt die p-seitige Abschlussschicht auch an die p-leitende Schicht an.

Der optoelektronische Halbleiterkörper, insbesondere zumindest die Quantentopfstruktur, die n-leitende Schicht und die p-leitende Schicht, enthält ein Halbleitermaterial, das aus der ersten Komponente Indium und einer von der ersten Komponente verschiedenen zweiten Komponente zusammengesetzt ist. Dabei müssen nicht alle Schichten des Halbleiterkörpers die erste Komponente des Halbleitermaterials enthalten. Vorzugsweise ist die erste Komponente jedoch zumindest in der/den Quantentopfschicht(en), gegebenenfalls in der/den Barriereschicht(en), der n-seitigen Abschlussschicht und der p-seitigen Abschlussschicht enthalten. Die Zusammensetzung der zweiten Komponente muss nicht in allen Schichten des Halbleiterkörpers gleich sein. Beispielsweise kann die zweite Komponente mehrere Elemente enthalten, deren Stoffmengenanteile an der zweiten Komponente in verschiedenen Schichten des Halbleiterkörpers unterschiedlich sind.

Das Halbleitermaterial ist beispielsweise ein hexagonales Verbindungshalbleitermaterial. Ein hexagonales Verbindungshalbleitermaterial weist eine hexagonale Gitterstruktur auf. Beispielsweise handelt es sich bei dem hexagonalen Verbindungshalbleitermaterial um eine binäre, ternäre und/oder quaternäre Verbindung von Elementen der dritten und fünften Hauptgruppe, beispielsweise um ein Nitrid-Verbindungshalbleitermaterial. Es kann sich zum Beispiel um eine der folgenden Halbleiterstrukturen handeln: AlGaN, GaN, InAlGaN.

Dabei muss das Halbleitermaterial nicht zwingend eine mathematisch exakte Zusammensetzung nach einer der obigen Formeln aufweisen. Vielmehr kann es einen oder mehrere Dotierstoffe sowie zusätzliche Bestandteile aufweisen. Der Einfachheit halber beinhalten obige Formeln jedoch nur die wesentlichen Bestandteile des Kristallgitters, auch wenn diese teilweise durch geringere Mengen weiterer Stoffe ersetzt sein können.

Der Stoffmengenanteil der ersten Komponente an dem Halbleitermaterial ist in jeder der Quantentopfschichten größer als in der n-seitigen Abschlussschicht, in der p-seitigen Abschlussschicht und in der Barriereschicht beziehungsweise in den Barriereschichten des Schichtstapels. Auf diese Weise ist insbesondere eine Bandstruktur der Quantentopfstruktur erzielt, bei der die Quantentopfstruktur im Bereich der Quantentopfschichten eine geringere Bandlücke hat als im Bereich der n-seitigen Abschlussschicht, der p-seitigen Abschlussschicht und gegebenenfalls der Barriereschicht(en). Bei einer Ausgestaltung ist der Stoffmengenanteil der ersten Komponente in allen Quantentopfschichten gleich groß.

Der Stoffmengenanteil der ersten Komponente ist in der n-seitigen Abschlussschicht größer als in der n-leitenden Schicht. In der p-seitigen Abschlussschicht ist der Stoffmengenanteil der ersten Komponente vorzugsweise größer als in der p-leitenden Schicht.

Beispielsweise bei einem Halbleiterkörper, der ein hexagonales Verbindungshalbleitermaterial enthält - etwa bei einem auf dem III/V-Halbleitermaterialsystem InAlGaN, also InₓAl_{y}Ga_{1-x-y}N mit 0 ≤ x ≤ 1, 0 ≤ y ≤ 1 und x + y ≤ 1, basierenden Halbleiterkörper - treten in der Quantentopfstruktur piezoelektrische Felder auf. Die piezoelektrischen Felder stellen energetische Barrieren für die in der Quantentopfstruktur wandernden Ladungsträger dar.

Diese Ladungsträgerbarrieren entstehen, insbesondere aufgrund der polaren Wurtzit-Kristallstruktur, wenn sich bei Änderungen des Stoffmengenanteils der ersten Komponente - d.h. in diesem Fall bei Änderung des In-Anteils - Verspannungen in dem Halbleitermaterial bilden.

Die Erfinder haben festgestellt, dass bei dem Halbleiterkörper gemäß der vorliegenden Anmeldung diese Barrieren besonders klein sind, so dass der Halbleiterkörper eine besonders geringe Vorwärtsspannung hat. Beispielsweise ist die Vorwärtsspannung gegenüber Halbleiterkörpern verringert, bei denen die n-seitige Abschlussschicht und/oder die p-seitige Abschlussschicht frei von der ersten Komponente des Halbleiterkörpers sind. Auch gegenüber einem Halbleiterkörper, bei dem beispielsweise zwischen der n-seitigen Abschlussschicht und der ersten Quantentopfschicht des Schichtstapels - beziehungsweise der einzelnen Quantentopfschicht - eine weitere Schicht angeordnet ist, welche die erste Komponente des Halbleitermaterials in einem geringeren Stoffmengenanteil enthält als die n-seitige Abschlussschicht, ist die Vorwärtsspannung mit Vorteil verringert.

Der Halbleiterkörper hat bei einer Ausgestaltung ein Emissionsmaximum bei einer Wellenlänge von größer oder gleich 440 nm, vorzugsweise von größer oder gleich 460 nm, besonders bevorzugt von größer oder gleich 480 nm hat. Beispielsweise liegt das Emissionsmaximum im grünen Spektralbereich. Bei einer Ausgestaltung ist die Wellenlänge des Emissionsmaximums kleiner oder gleich 1400 nm.

Mit zunehmender Wellenlänge des Emissionsmaximums nimmt die Bandlücke der Quantentopfschicht(en) ab, wodurch grundsätzlich auch die Vorwärtsspannung sinken sollte. Um die Bandlücke zu verkleinern wird jedoch der Stoffmengenanteil der ersten Komponente an dem Halbleitermaterial in den Quantentopfschichten bzw. in der einzelnen Quantentopfschicht erhöht. Bei konventionellen Leuchtdioden aus InAlGaN führt dies zu einer derartigen Erhöhung der Ladungsträgerbarrieren, dass die Vorwärtsspannung nahezu unabhängig von der Emissionswellenlänge ist.

Dagegen wirkt sich die Aufteilung der Ladungsträgerbarrieren auf den Übergang zwischen der n-leitenden Schicht und der n-seitigen Abschlussschicht und den Übergang zwischen der n-seitigen Abschlussschicht und der einzelnen Quantentopfschicht bzw. der ersten Quantentopfschicht bei dem Halbleiterkörper gemäß der vorliegenden Anmeldung besonders vorteilhaft aus, wenn der Stoffmengenanteil der ersten Komponente in der/den Quantentopfschicht(en) groß ist. Die mit dem Halbleiterkörper gemäß der vorliegenden Anmeldung erzielbare Reduzierung der Vorwärtsspannung ist daher bei größeren Wellenlängen besonders ausgeprägt.

Gemäß einer anderen Ausgestaltung ist der Stoffmengenanteil der ersten Komponente an dem Halbleitermaterial in der Barriereschicht beziehungsweise in den Barriereschichten mindestens so groß wie in der n-seitigen Abschlussschicht. Gemäß einer Weiterbildung ist alternativ oder zusätzlich der Stoffmengenanteil der ersten Komponente an dem Halbleitermaterial in der Barriereschicht beziehungsweise in den Barriereschichten mindestens so groß wie in der p-seitigen Abschlussschicht.

Der Stoffmengenanteil der ersten Komponente kann in der n-seitigen Abschlussschicht und in der p-seitigen Abschlussschicht gleich groß sein. Es ist auch denkbar, dass der Stoffmengenanteil der ersten Komponente in der n-seitigen Abschlussschicht einen anderen Wert hat als in der p-seitigen Abschlussschicht. Der Stoffmengenanteil der ersten Komponente an dem Halbleitermaterial in der/den Barriereschicht(en) ist vorzugsweise mindestens so groß wie der größere der Stoffmengenanteile der ersten Komponente in der n-seitigen Abschlussschicht und in der p-seitigen Abschlussschicht.

Beispielsweise hat der Stoffmengenanteil der ersten Komponente an dem Halbleitermaterial in der Barriereschicht beziehungsweise den Barriereschichten einen Wert, der zwischen dem Stoffmengenanteil der ersten Komponente in den Quantentopfschichten und dem größeren der Stoffmengenanteile der ersten Komponente in der n-seitigen Abschlussschicht und in der p-seitigen Abschlussschicht liegt. Bei einer anderen Ausgestaltung ist der Stoffmengenanteil der ersten Komponente an dem Halbleitermaterial in der n-seitigen Abschlussschicht, in der Barriereschicht beziehungsweise den Barriereschichten und in der p-seitigen Abschlussschicht gleich groß.

Im vorliegenden Zusammenhang wird unter einem "gleich großen Stoffmengenanteil" der ersten Komponente in zwei Schichten verstanden, dass sich der Stoffmengenanteil - insbesondere der über die Dicke der jeweiligen Schicht gemittelte Stoffmengenanteil - der ersten Komponente zwischen den Schichten um 5 % oder weniger unterscheidet. Anders ausgedrückt liegt der Stoffmengenanteil in der zweiten der zwei Schichten in einem Bereich zwischen dem 0,95-fachen des Stoffmengenanteils in der ersten der zwei Schichten und dem 1,05-fachen des Stoffmengenanteils in der ersten Schicht. Vorzugsweise unterscheidet sich der Stoffmengenanteil um 1 % oder weniger, besonders bevorzugt um 0,5 % oder weniger.

Vorteilhafterweise kann die Vorwärtsspannung auf diese Weise weiter verringert werden. Beispielsweise kann die Vorwärtsspannung gegenüber einem Halbleiterkörper verringert sein, bei dem die Barriereschicht(en) frei von der ersten Komponente des Halbleiterkörpers sind oder der zwischen zwei aufeinanderfolgenden Quantentopfschichten eine Mehrzahl von Barriereschichten mit unterschiedlichem Anteil der ersten Komponente aufweist.

Die n-leitende Schicht weist einen p-seitigen Randbereich auf und die n-seitige Abschlussschicht weist einen n-seitigen Randbereich auf. Der p-seitige Randbereich der n-leitenden Schicht und der n-seitige Randbereich der n-seitigen Abschlussschicht grenzen aneinander an. Insbesondere haben sie eine gemeinsame Grenzfläche. Der p-seitige Randbereich der n-leitenden Schicht und der n-seitige Randbereich der n-seitigen Abschlussschicht sind mit einem n-Dotierstoff dotiert. Beispielsweise handelt es sich bei dem n-Dotierstoff um Silizium. Der n-Dotierstoff liegt in dem p-seitigen Randbereich der n-leitenden Schicht und in dem n-seitigen Randbereich der n-seitigen Abschlussschicht in einer Konzentration von größer oder gleich 5 x 10¹⁸ Atome/cm³ vor. Beispielsweise beträgt die Konzentration des n-Dotierstoffs zwischen 5 x 10¹⁸ Atome/cm³ und 5 x 10¹⁹ Atome/cm³, wobei die Grenzen eingeschlossen sind. Mittels des n-Dotierstoffs ist insbesondere die piezoelektrische Barriere, die sich zwischen der n-leitenden Schicht und der n-seitigen Abschlussschicht ausbildet, mit Vorteil reduziert, so dass die Vorwärtsspannung des Halbleiterkörpers weiter verringert ist.

Die n-seitige Abschlussschicht weist einen p-seitigen Randbereich auf, der an die einzelne Quantentopfschicht beziehungsweise an den Schichtstapel angrenzt - insbesondere eine gemeinsame Grenzfläche mit der ersten Quantentopfschicht hat - und der nominell undotiert ist. Auf diese Weise ist die Gefahr verringert, dass der n-Dotierstoff die Emissionseigenschaften und/oder Strahlungsempfangs-Eigenschaften der Quantentopfstruktur beeinträchtigt.

Darunter, dass der Randbereich "nominell undotiert" ist, wird im vorliegenden Zusammenhang, verstanden, dass der Randbereich undotiert oder gering n-dotiert ist. "Gering n-dotiert" bedeutet dabei, dass die Konzentration des n-Dotierstoffs höchstens 0,1-mal so groß, vorzugsweise höchstens 0,05-mal so groß und insbesondere höchstens 0,01-mal so groß ist, wie die Konzentration des n-Dotierstoffs in einem n-dotierten Bereich, insbesondere in dem n-dotierten Randbereich der n-seitigen Abschlussschicht. Beispielsweise ist die Konzentration des n-Dotierstoffs in dem nominell undotierten Bereich kleiner oder gleich 1 x 10¹⁸ Atome/cm³, vorzugsweise kleiner oder gleich 5 x 10¹⁷ Atome/cm³, insbesondere ist sie kleiner oder gleich 1 x 10¹⁷ Atome/cm³.

Die n-seitige Abschlussschicht hat bei einer Ausgestaltung eine Schichtdicke von größer oder gleich 10 nm, beispielsweise von größer oder gleich 50 nm. Bei einer Weiterbildung hat der p-seitige Randbereich eine Schichtdicke von größer oder gleich 10 nm, vorzugsweise von größer oder gleich 50 nm. Derartige Schichtdicken sind besonders vorteilhaft für die Reduzierung der Vorwärtsspannung.

Bei einer Weiterbildung hat die n-seitige Abschlussschicht eine Schichtdicke von kleiner oder gleich 120 nm. Bei größeren Schichtdicken der n-seitigen Abschlussschicht ist die Gefahr erhöht, dass bei der Herstellung der Quantentopfstruktur keine zufriedenstellende Kristallqualität erzielt wird.

Die erste Komponente des Halbleitermaterials wird von In gebildet. Die zweite Komponente des Halbleitermaterials wird beispielsweise von Stickstoff und mindestens einem Material der aus Al und Ga bestehenden Gruppe gebildet. Beispielsweise handelt es sich bei dem Halbleitermaterial um InₓAl_{y}Ga_{1-x-y}N. Die von In gebildete erste Komponente hat beispielsweise in der n-seitigen Abschlussschicht einen Anteil x ≥ 0,05. Der Anteil x entspricht insbesondere dem Stoffmengenanteil von In oder ist zumindest proportional zu diesem.

Die n-leitende Schicht ist bei einer Ausgestaltung frei von der ersten Komponente des Halbleitermaterials. Bei einer weiteren Ausgestaltung ist die p-leitende Schicht frei von der ersten Komponente des Halbleitermaterials. Insbesondere bestehen bei diesen Ausgestaltungen die n-leitende Schicht und/oder die p-leitende Schicht aus der zweiten Komponente des Halbleitermaterials.

Bei einer weiteren Ausgestaltung steigt der Stoffmengenanteil der ersten Komponente an dem Halbleitermaterial in Richtung von der n-leitenden Schicht zu dem Schichtstapel - beziehungsweise, im Fall einer Einfachquantentopfstruktur, zu der einzelnen Quantentopfschicht - hin innerhalb des n-seitigen Randbereichs der n-seitigen Abschlussschicht kontinuierlich oder in mehreren Stufen an. Die Piezobarriere ist auf diese Weise besonders schwach ausgebildet, so dass die erzielbare Vorwärtsspannung besonders gering ist.

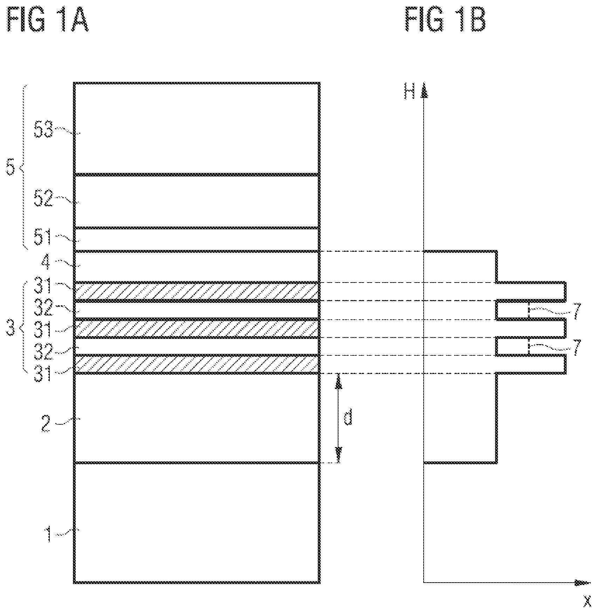

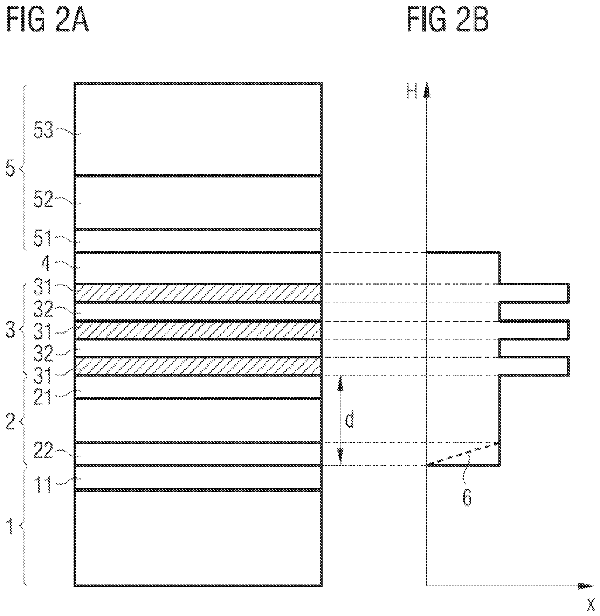

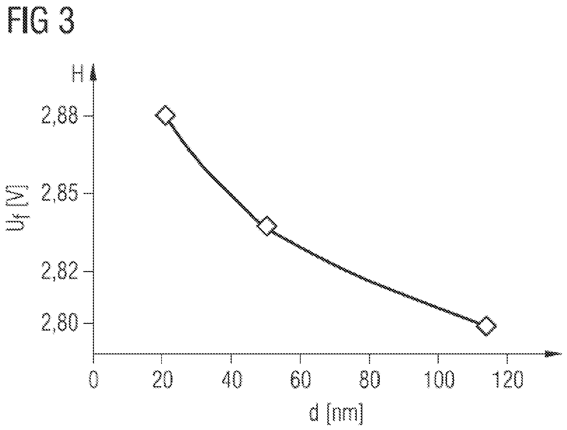

Weitere Vorteile und vorteilhafte Ausgestaltungen und Weiterbildungen des optoelektronischen Halbleiterkörpers ergeben sich aus der folgenden Beschreibung eines Ausführungsbeispiels der Erfindung (Figuren 2A und 2B) und weiteren Beispielen (Figuren 1A, 1B und 3), die nicht sämtliche Merkmale der Erfindung aufweisen.

Es zeigen:
- Figur 1A: einen schematischen Querschnitt durch einen optoelektronischen Halbleiterkörper gemäß einem ersten Beispiel,
- Figur 1B: eine schematische Darstellung des Anteils der ersten Komponente des Halbleitermaterials in dem Halbleiterkörper gemäß dem Beispiel der Figur 1A,
- Figur 2A: einen schematischen Querschnitt durch einen optoelektronischen Halbleiterkörper gemäß einem erfindungsgemäßen Ausführungsbeispiel,
- Figur 2B: eine schematische Darstellung des Anteils der ersten Komponente des Halbleitermaterials in dem optoelektronischen Halbleiterkörper gemäß der Figur 2A, und
- Figur 3: die Vorwärtsspannung des optoelektronischen Halbleiterkörpers gemäß dem ersten Beispiel in Abhängigkeit von der Schichtdicke der n-seitigen Abschlussschicht.

In den Figuren sind gleiche oder ähnliche Elemente sowie ähnlich wirkende Elemente mit den gleichen Bezugszeichen versehen. Die Figuren sind nicht als maßstäblich zu betrachten. Vielmehr können einzelne Elemente wie zum Beispiel Schichten übertrieben groß, insbesondere übertrieben dick dargestellt sein, um die Verständlichkeit und/oder die Darstellbarkeit zu erleichtern.

Figur 1A zeigt einen schematischen Querschnitt durch einen optoelektronischen Halbleiterkörper gemäß einem ersten Beispiel.

Der optoelektronische Halbleiterkörper besteht aus dem Halbleitermaterial InₓAl_{y}Ga_{1-x-y}N. Er enthält eine n-leitende Schicht 1, bei der es sich vorliegend um eine mit Silizium als n-Dotierstoff dotierte GaN-Schicht handelt. Auf der der n-leitenden Schicht 1 gegenüberliegenden Seite weist der Halbleiterkörper eine p-leitende Schicht 5 auf.

Die p-leitende Schicht 5 hat bei dem vorliegenden Ausführungsbeispiel eine Mehrschichtstruktur. In Richtung von der n-leitenden Schicht 1 weg weist sie zunächst eine undotierte GaN-Schicht 51 auf. An diese grenzt eine p-dotierte AlGaN-Schicht 52 an. Auf die von der n-leitenden Schicht 1 abgewandte Seite der p-dotierten AlGaN-Schicht 52 ist eine p-dotierte GaN-Schicht 53 aufgebracht. Die p-dotierte AlGaN-Schicht 52 und/oder die p-dotierte GaN-Schicht 53 sind beispielsweise mit Magnesium als p-Dotierstoff dotiert. Der Aufbau der p-leitenden Schicht 5 ist jedoch nicht auf diese Mehrschichtstruktur beschränkt.

Zwischen der n-leitenden Schicht 1 und der p-leitenden Schicht 5 ist eine Mehrfachquantentopfstruktur angeordnet. Diese besteht aus einer n-seitigen Abschlussschicht 2, einem Schichtstapel 3 und einer p-seitigen Abschlussschicht 4.

Die n-seitige Abschlussschicht 2 grenzt an der vom Schichtstapel 3 abgewandten Seite an die n-leitende Schicht 1 an. Die p-seitige Abschlussschicht 4 grenzt an der vom Schichtstapel 3 abgewandten Seite an die n-leitende Schicht 5, vorliegend an die GaN-Schicht 51, an.

Der Schichtstapel 3 besteht vorliegend aus drei Quantentopfschichten 31 und zwei Barriereschichten 32. Der Schichtstapel kann aber auch eine andere Anzahl n, d.h. n = 2 oder n ≥ 4, von Quantentopfschichten 31 enthalten. Dann enthält er n-1 Barriereschichten 32.

In Richtung von der n-leitenden Schicht 1 zur p-leitenden Schicht 5 folgen jeweils eine Quantentopfschicht 31 und eine Barriereschicht 32 abwechselnd aufeinander. Der Schichtstapel 3 wird in Richtung zur n-leitenden Schicht 1 hin und in Richtung zur p-leitenden Schicht 5 hin jeweils von einer Quantentopfschicht 31 abgeschlossen.

Auf diese Weise ist zwischen jeweils zwei aufeinander folgenden Quantentopfschichten 31 genau eine Barriereschicht 32 angeordnet. Diese Barriereschicht 32 grenzt n-seitig, das heißt in Richtung zur n-leitenden Schicht 1 hin, an die erste der beiden aufeinander folgenden Quantentopfschichten 31 an. P-seitig, das heißt in Richtung zur p-leitenden Schicht 5 hin, grenzt diese Barriereschicht 32 an die zweite der beiden aufeinander folgenden Quantentopfschichten 31 an.

Die n-seitige Abschlussschicht 2 grenzt p-seitig an eine erste Quantentopfschicht 31 des Schichtstapels 3 an. Die p-seitige Abschlussschicht 4 grenzt n-seitig an eine letzte Quantentopfschicht 31 des Schichtstapels 3 an.

Es ist auch denkbar, dass der optoelektronische Halbleiterkörper anstelle des Schichtstapels 3 eine einzelne Quantentopfschicht 31 enthält. In diesem Fall hat die einzelne Quantentopfschicht beispielsweise eine Schichtdicke von 5 nm oder mehr, vorzugsweise von 10 nm oder mehr. Enthält der Halbleiterkörper eine einzelne Quantentopfschicht 31, grenzen insbesondere die n-seitige Abschlussschicht 2 p-seitig und die p-seitige Abschlussschicht 4 n-seitig an die einzelne Quantentopfschicht 31 an. Der Halbleiterkörper enthält in diesem Fall insbesondere keine Barriereschichten 32 zwischen den Abschlussschichten 2, 4 und der einzelnen Quantentopfschicht 31.

Figur 1B zeigt den Anteil x der von In gebildeten ersten Komponente des Halbleitermaterials des Halbleiterkörpers in Abhängigkeit von der Position H im Halbleiterkörper. Die Position H gibt dabei insbesondere den Abstand von der n-seitigen Hauptfläche der n-leitenden Schicht 1, in Richtung von der n-leitenden Schicht 1 zur p-leitenden Schicht 5 gesehen, an. Die Figuren 1A und 1B sind bezüglich der Position H gleich skaliert, so dass jede Position auf der H-Achse in Figur 1B einer waagrechten Ebene in dem Schichtaufbau der Figur 1A in gleicher Höhe entspricht.

Der Anteil x der von In gebildeten ersten Komponente des Halbleitermaterials ist in den Quantentopfschichten 31 größer als in den Barriereschichten 32, der n-seitigen Abschlussschicht 2 und der p-seitigen Abschlussschicht 4. Die n-leitende Schicht 1 und die p-leitende Schicht 5 enthalten vorliegend - zumindest nominell - kein Indium.

Der Anteil x der von In gebildeten ersten Komponente des Halbleitermaterials ist in der n-seitigen Abschlussschicht 2, in den Barriereschichten 32 und in der p-seitigen Abschlussschicht 4 gleich hoch. Beispielsweise beträgt er 0,05 ≤ x ≤ 0,25, beispielsweise x = 0,05.

Die Veränderung des Indium-Anteils x an der Grenzfläche zwischen n-leitender Schicht 1 und n-seitiger Abschlussschicht 2 bewirkt dort eine erste energetische Ladungsträgerbarriere aufgrund von piezoelektrischen Feldern. An der Grenzfläche zwischen der n-seitigen Abschlussschicht 2 und der ersten Quantentopfschicht 31 entsteht auf diese Weise eine zweite energetische Barriere.

Bei dem optoelektronischen Halbleiterkörper ist mittels der n-seitigen Abschlussschicht der Indium-Anteil bereits n-seitig von der ersten Quantentopfschicht 31 erhöht. Er wird zwischen der n-seitigen Abschlussschicht 32 und der ersten Quantentopfschicht auch nicht wieder abgesenkt. Somit ist zwischen der n-seitigen Abschlussschicht 2 und der ersten Quantentopfschicht 31 des Schichtstapels 3 der Sprung im Indiumanteil x bei dem vorliegenden Halbleiterkörper vergleichsweise gering.

Die gesamte von den Ladungsträgern von der n-leitenden Schicht 1 bis zur ersten Quantentopfschicht 31 hin zu überwindende Barriere ist aufgrund der räumlichen Trennung zwischen der ersten Barriere an der Grenzfläche zwischen n-leitender Schicht 1 und n-seitiger Abschlussschicht 2 sowie der zweiten Barriere an der Grenzfläche zwischen n-seitiger Abschlussschicht 2 und erster Quantentopfschicht 31 besonders gering. Analog gilt dies auch für die Ladungsträgerbarrieren an der p-Seite des Schichtstapels 3 zwischen der letzten Quantentopfschicht 31, die an die p-seitige Abschlussschicht 4 angrenzt und der Grenzfläche zwischen der p-seitigen Abschlussschicht 4 und der p-leitenden Schicht 5.

Bei einer Variante dieses Beispiels ist der Anteil x in den Barriereschichten 32 größer als in der n-seitigen Abschlussschicht 2 und als in der p-seitigen Abschlussschicht 4. Dies ist in Figur 1B mit den gestrichelten Linien 7 angedeutet. Auf diese Weise kann eine besonders vorteilhafte, insbesondere eine besonders homogene, Ladungsträgerverteilung auf die einzelnen Quantentopfschichten 31 erzielt werden.

Insbesondere können besonders kleine Piezo-Barrieren zwischen den einzelnen Quantentopfschichten 31 erzielt werden.

Die Erfinder haben festgestellt, dass die erzielbare Vorwärtsspannung besonders klein ist, wenn der Indium-Anteil x in den Barriereschichten 32 mindestens so groß ist wie in der n-seitigen Abschlussschicht 2 und in der p-leitenden Abschlussschicht 4, beispielsweise wenn der Indium-Anteil x in der n-seitigen Abschlussschicht 2, in der p-leitenden Abschlussschicht 4 und in den Barriereschichten 32 gleich groß ist. Zusätzliche Barriereschichten zwischen aufeinander folgenden Quantentopfschichten 31, die beispielsweise einen geringeren Indium-Gehalt oder kein Indium aufweisen, würden die Vorwärtsspannung des Halbleiterkörpers nachteilig erhöhen.

Die Erfinder haben festgestellt, dass die Vorwärtsspannung U_{f} mit zunehmender Dicke d der n-seitigen Abschlussschicht 2 abnimmt. Dies ist für einen optoelektronischen Halbleiterkörper, der elektromagnetische Strahlung mit einem Emissionsmaximum bei einer Wellenlänge von 480 nm emittiert, in Figur 3 exemplarisch dargestellt.

Die Vorwärtsspannung U_{f} nimmt von 2,88 V bei einer Schichtdicke d der n-seitigen Abschlussschicht 2 von 20 nm bis zu einer Vorwärtsspannung U_{f} von 2,80 V bei einer Schichtdicke d von etwa 115 nm ab. Konventionelle InAlGaN-Halbleiterkörper mit der gleichen Wellenlänge des Emissionsmaximums haben eine Vorwärtsspannung von etwa 3,0 V bis 3,3 V.

Die Schichtdicke d ist vorzugsweise kleiner oder gleich 120 nm, vorzugsweise kleiner oder gleich 100 nm. Die Erfinder haben festgestellt, dass bei größeren Schichtdicken d der n-seitigen Abschlussschicht 2 die Gefahr steigt, dass die Kristallqualität der Mehrfachquantentopfstruktur beeinträchtigt ist.

Die Figuren 2A und 2B zeigen einen schematischen Querschnitt durch einen optoelektronischen Halbleiterkörper gemäß einem Ausführungsbeispiel der Erfindung und den Indium-Anteil x in Abhängigkeit von der Position H im Halbleiterkörper, analog zur Darstellung des ersten Beispiels in den Figuren 1A und 1B.

Der Halbleiterkörper gemäß dem erfindungsgemäßen Ausführungsbeispiel unterscheidet sich dadurch vom Halbleiterkörper des ersten Beispiels, dass die n-seitige Abschlussschicht 2 einen n-seitigen Randbereich 22 aufweist, der mit einem n-Dotierstoff wie Silizium dotiert ist und einen p-seitigen Randbereich 21 aufweist, der nominell undotiert ist.

Der nominell undotierte p-seitige Randbereich 21 grenzt an die erste Quantentopfschicht 31 des Schichtstapels 3 an. Der n-seitige Randbereich 22 ist auf der von dem Schichtstapel 3 abgewandten Seite der n-seitigen Abschlussschicht 2 angeordnet und grenzt an einen p-seitigen Randbereich 11 der n-leitenden Schicht 1 an.

Der p-seitige Randbereich 11 der n-leitenden Schicht 1 ist ebenfalls mit dem n-Dotierstoff, zum Beispiel Silizium, n-dotiert. Vorliegend ist - wie beim ersten Ausführungsbeispiel - die gesamte n-leitende Schicht 1 mit Silizium als n-Dotierstoff dotiert.

In dem p-seitigen Randbereich 11 der n-leitenden Schicht 1 und dem n-seitigen Randbereich 22 der n-seitigen Abschlussschicht 2 liegt der n-Dotierstoff in einer Konzentration zwischen 5 x 10¹⁸ Atome/cm³ und 5 x 10¹⁹ Atome/cm³ vor, wobei die Grenzen eingeschlossen sind.

Die Erfinder haben festgestellt, dass mittels einer n-Dotierung des n-seitigen Randbereichs 22 der n-seitigen Abschlussschicht 2 die energetische Ladungsträgerbarriere an der Grenzfläche zwischen der n-leitenden Schicht 1 und der n-seitigen Abschlussschicht 2, das heißt vorliegend an der Grenzfläche zwischen dem p-seitigen Randbereich 11 der n-leitenden Schicht 1 und dem n-seitigen Randbereich 22 der n-seitigen Abschlussschicht 2 mit Vorteil weiter verringert werden kann. Zum Beispiel bei einem optoelektronischen Halbleiterkörper, bei dem die n-seitige Abschlussschicht 2 eine Schichtdicke von d = 20 nm hat, und der ein Emissionsmaximum bei einer Wellenlänge von 480 nm hat - entsprechend einer Energielücke von 2,58 Elektronenvolt - kann gegenüber dem ersten Ausführungsbeispiel die Vorwärtsspannung U_{f} von 2,88 V auf beispielsweise 2,83 V verringert werden.

Bei einer Variante dieses Ausführungsbeispiels steigt innerhalb des n-dotierten, n-seitigen Randbereichs 22 der n-seitigen Abschlussschicht 2 der Indium-Anteil x in Richtung von der n-leitenden Schicht 1 zum Schichtstapel 3 hin kontinuierlich an, wie in Figur 2B durch die gepunktete Linie 6 angedeutet. Auf diese Weise kann die energetische Ladungsträgerbarriere weiter verringert werden.

Diese Patentanmeldung beansprucht die Priorität der deutschen Patentanmeldungen 102009034588.4 und 102009040438.4.

## Patentansprüche

1. Optoelektronischer Halbleiterkörper, der ein Halbleitermaterial enthält, das aus einer ersten Komponente und einer von der ersten Komponente verschiedenen zweiten Komponente zusammengesetzt ist, und der eine zwischen einer n-leitenden Schicht (1) und einer p-leitenden Schicht (5) angeordnete Mehrfachquantentopfstruktur aufweist, die Mehrfachquantentopfstruktur bestehend aus
- einem Schichtstapel (3), der aus einer Mehrzahl von Quantentopfschichten (31) und mindestens einer Barriereschicht (32) besteht, wobei zwischen jeweils zwei aufeinander folgenden Quantentopfschichten (31) eine Barriereschicht (32) angeordnet ist, die an beide Quantentopfschichten (31) angrenzt;
- einer n-seitigen Abschlussschicht (2), die an den Schichtstapel (3) und die n-leitende Schicht (1) angrenzt; und
- einer p-seitigen Abschlussschicht (4), die zwischen dem Schichtstapel (3) und der p-leitenden Schicht (4) angeordnet ist und an den Schichtstapel (3) angrenzt, wobei die erste Komponente des Halbleitermaterials von In gebildet wird, und wobei der Stoffmengenanteil (x) der ersten Komponente an dem Halbleitermaterial
- in jeder der Quantentopfschichten (31) größer ist als in der n-seitigen Abschlussschicht (2), in der mindestens einen Barriereschicht (32) und in der p-seitigen Abschlussschicht (4); und
- in der n-seitigen Abschlussschicht (2) größer ist als in der n-leitenden Schicht (1) und in der p-seitigen Abschlussschicht (4) größer ist als in der p-leitenden Schicht (5), und wobei
- die n-leitende Schicht (1) einen p-seitigen Randbereich (11) aufweist, der an einen n-seitigen Randbereich (22) der n-seitigen Abschlussschicht (2) angrenzt,
- der p-seitige Randbereich (11) der n-leitenden Schicht (1) und der n-seitige Randbereich (22) der n-seitigen Abschlussschicht (2) mit einem n-Dotierstoff dotiert sind,
- die n-seitige Abschlussschicht (2) einen p-seitigen Randbereich (21) aufweist, der an den Schichtstapel (3) direkt angrenzt und der nominell undotiert ist, und
- der n-Dotierstoff in dem p-seitigen Randbereich (11) der n-leitenden Schicht (1) und in dem n-seitigen Randbereich (22) der n-seitigen Abschlussschicht (2) in einer Konzentration von größer oder gleich 5 x 10¹⁸ Atome/cm³ vorliegt.

2. Optoelektronischer Halbleiterkörper nach Anspruch 1, wobei der Stoffmengenanteil (x) der ersten Komponente an dem Halbleitermaterial in der mindestens einen Barriereschicht (32) mindestens so groß ist wie in der n-seitigen Abschlussschicht (2).

3. Optoelektronischer Halbleiterkörper nach einem der vorhergehenden Ansprüche, wobei der Stoffmengenanteil (x) der ersten Komponente an dem Halbleitermaterial in der mindestens einen Barriereschicht (32) mindestens so groß ist wie in der p-seitigen Abschlussschicht (4).

4. Optoelektronischer Halbleiterkörper nach einem der vorhergehenden Ansprüche, wobei der Stoffmengenanteil (x) der ersten Komponente an dem Halbleitermaterial in der n-seitigen Abschlussschicht (2), in der mindestens einen Barriereschicht (32) und in der p-seitigen Abschlussschicht (4) gleich groß ist.

5. Optoelektronischer Halbleiterkörper, der ein Halbleitermaterial enthält, das aus einer ersten Komponente und einer von der ersten Komponente verschiedenen zweiten Komponente zusammengesetzt ist, und der eine zwischen einer n-leitenden Schicht (1) und einer p-leitenden Schicht (5) angeordnete Einfachquantentopfstruktur aufweist, die Einfachquantentopfstruktur bestehend aus
- einer einzelnen Quantentopfschicht (31);
- einer n-seitigen Abschlussschicht (2), die an die Quantentopfschicht (31) und die n-leitende Schicht (1) angrenzt; und
- einer p-seitigen Abschlussschicht (4), die zwischen der Quantentopfschicht (3) und der p-leitenden Schicht (4) angeordnet ist und an die Quantentopfschicht (31) angrenzt,
wobei die erste Komponente des Halbleitermaterials von In gebildet wird, und wobei der Stoffmengenanteil (x) der ersten Komponente an dem Halbleitermaterial
- der Quantentopfschicht (31) größer ist als in der n-seitigen Abschlussschicht (2) und in der p-seitigen Abschlussschicht (4); und
- in der n-seitigen Abschlussschicht (2) größer ist als in der n-leitenden Schicht (1) und in der p-seitigen Abschlussschicht (4) größer ist als in der p-leitenden Schicht (5), und wobei
- die n-leitende Schicht (1) einen p-seitigen Randbereich (11) aufweist, der an einen n-seitigen Randbereich (22) der n-seitigen Abschlussschicht (2) angrenzt,
- der p-seitige Randbereich (11) der n-leitenden Schicht (1) und der n-seitige Randbereich (22) der n-seitigen Abschlussschicht (2) mit einem n-Dotierstoff dotiert sind,
- die n-seitige Abschlussschicht (2) einen p-seitigen Randbereich (21) aufweist, der an die einzelne Quantentopfschicht (31) direkt angrenzt und der nominell undotiert ist, und
- der n-Dotierstoff in dem p-seitigen Randbereich (11) der n-leitenden Schicht (1) und in dem n-seitigen Randbereich (22) der n-seitigen Abschlussschicht (2) in einer Konzentration von größer oder gleich 5 x 10¹⁸ Atome/cm³ vorliegt.

6. Optoelektronischer Halbleiterkörper nach einem der vorhergehenden Ansprüche, wobei die n-seitige Abschlussschicht (2) eine Schichtdicke (d) von größer oder gleich 10 nm, insbesondere von größer oder gleich 50 nm hat.

7. Optoelektronischer Halbleiterkörper nach einem der vorhergehenden Ansprüche, wobei der p-seitige Randbereich (21) der n-seitigen Abschlussschicht (2) eine Schichtdicke von größer oder gleich 10 nm hat.

8. Optoelektronischer Halbleiterkörper nach einem der vorhergehenden Ansprüche, wobei die zweite Komponente des Halbleitermaterials Stickstoff und mindestens ein Material der Gruppe, die aus Al und Ga besteht, enthält.

9. Optoelektronischer Halbleiterkörper nach Anspruch 8, wobei das Halbleitermaterial InₓAl_{y}Ga_{1-x-y}N ist, mit 0 ≤ x ≤ 1, 0 ≤ y ≤ 1 und x+y ≤ 1, und die von In gebildete erste Komponente in der n-seitigen Abschlussschicht einen Anteil x ≥ 0,05 hat.

10. Optoelektronischer Halbleiterkörper nach einem der vorhergehenden Ansprüche, wobei die n-leitende Schicht (1) frei von der ersten Komponente des Halbleitermaterials ist.

11. Optoelektronischer Halbleiterkörper nach einem der vorhergehenden Ansprüche, wobei der Stoffmengenanteil (x) der ersten Komponente innerhalb der n-seitigen Abschlussschicht (2), insbesondere innerhalb des n-seitigen Randbereichs (22) der n-seitigen Abschlussschicht (2), in Richtung von der n-leitenden Schicht (1) weg kontinuierlich oder in mehreren Stufen ansteigt.

## Claims

1. An optoelectronic semiconductor body, which contains a semiconductor material which is composed of a first component and a second component different from the first component, and which comprises a multiple quantum well structure arranged between an n-conducting layer (1) and a p-conducting layer (5), the multiple quantum well structure consisting of
- a layer stack (3), which consists of a plurality of quantum well layers (31) and at least one barrier layer (32), one barrier layer (32) being arranged between each pair of successive quantum wall layers (31), which barrier layer adjoins both quantum wall layers (31);
- an n-side terminating layer (2), which adjoins the layer stack (3) and the n-conducting layer (1); and
- a p-side terminating layer (4), which is arranged between the layer stack (3) and the p-conducting layer (4) and adjoins the layer stack (3),
wherein the first component of the semiconductor material is formed of In, and wherein the mole fraction (x) of the first component of the semiconductor material
- is greater in each of the quantum wall layers (31) than in the n-side terminating layer (2), in the at least one barrier layer (32) and in the p-side terminating layer (4); and
- is greater in the n-side terminating layer (2) than in the n-conducting layer (1) and is greater in the p-side terminating layer (4) than in the p-conducting layer (5), and wherein
- the n-conducting layer (1) comprises a p-side boundary zone (11), which adjoins an n-side boundary zone (22) of the n-side terminating layer (2),
- the p-side boundary zone (11) of the n-conducting layer (1) and the n-side boundary zone (22) of the n-side terminating layer (2) are doped with an n-dopant,
- the n-side terminating layer (2) comprises a p-side boundary zone (21), which directly adjoins the layer stack (3) and which is nominally undoped, and
- the n-dopant in the p-side boundary zone (11) of the n-conducting layer (1) and in the n-side boundary zone (22) of the n-side terminating layer (2) is present in a concentration of greater than or equal to 5 × 10¹⁸ atoms/cm³.

2. An optoelectronic semiconductor body according to claim 1, wherein the mole fraction (x) of the first component of the semiconductor material in the at least one barrier layer (32) is at least as great as in the n-side terminating layer (2).

3. An optoelectronic semiconductor body according to any one of the preceding claims, wherein the mole fraction (x) of the first component of the semiconductor material in the at least one barrier layer (32) is at least as great as in the p-side terminating layer (4).

4. An optoelectronic semiconductor body according to any one of the preceding claims, wherein the mole fraction (x) of the first component of the semiconductor material in the n-side terminating layer (2), in the at least one barrier layer (32) and in the p-side terminating layer (4) is of equal magnitude.

5. An optoelectronic semiconductor body, which contains a semiconductor material which is composed of a first component and a second component different from the first component, and which comprises a single quantum well structure arranged between an n-conducting layer (1) and a p-conducting layer (5), the single quantum well structure consisting of
- one single quantum well layer (31);
- an n-side terminating layer (2), which adjoins the quantum well layer (31) and the n-conducting layer (1); and
- a p-side terminating layer (4), which is arranged between the quantum well layer (3) and the p-conducting layer (4) and adjoins the quantum well layer (31), wherein the first component of the semiconductor material is formed of In, and wherein the mole fraction (x) of the first component of the semiconductor material
- of the quantum wall layer (31) is greater than in the n-side terminating layer (2) and in the p-side terminating layer (4); and
- is greater in the n-side terminating layer (2) than in the n-conducting layer (1) and is greater in the p-side terminating layer (4) than in the p-conducting layer (5), and wherein
- the n-conducting layer (1) comprises a p-side boundary zone (11), which adjoins an n-side boundary zone (22) of the n-side terminating layer (2),
- the p-side boundary zone (11) of the n-conducting layer (1) and the n-side boundary zone (22) of the n-side terminating layer (2) are doped with an n-dopant,
- the n-side terminating layer (2) comprises a p-side boundary zone (21), which directly adjoins the single quantum well layer (31) and which is nominally undoped,
- the n-dopant in the p-side boundary zone (11) of the n-conducting layer (1) and in the n-side boundary zone (22) of the n-side terminating layer (2) is present in a concentration of greater than or equal to 5 × 10¹⁸ atoms/cm³.

6. An optoelectronic semiconductor body according to any one of the preceding claims, wherein the n-side terminating layer (2) has a layer thickness (d) of greater than or equal to 10 nm, in particular of greater than or equal to 50 nm.

7. An optoelectronic semiconductor body according to any one of the preceding claims, wherein the p-side boundary zone (21) of the n-side terminating layer (2) has a layer thickness of greater than or equal to 10 nm.

8. An optoelectronic semiconductor body according to any one of the preceding claims, wherein the second component of the semiconductor material contains nitrogen and at least one material from the group consisting of Al and Ga.

9. An optoelectronic semiconductor body according to any one of the preceding claims,
wherein the semiconductor material is InₓAl_{y}Ga_{1-x-y}N, with 0 ≤ x ≤ 1, 0 ≤ y ≤ 1 and x+y ≤ 1, and wherein the first component formed of In has a content x ≥ 0.05.

10. An optoelectronic semiconductor body according to any one of the preceding claims, wherein the n-conductive layer (1) is free of the first component of the semiconductor material.

11. An optoelectronic semiconductor body according to any one of the preceding claims, wherein the mole fraction (x) of the first component within the n-side termination layer (2), in particular within the n-side boundary zone (22) of the n-side termination layer (2), increases continuously or in several steps in the direction away from the n-conducting layer (1).

## Revendications

1. Corps semi-conducteur optoélectronique comprenant un matériau semi-conducteur composé d'un premier composant et d'un second composant différent du premier composant, et présentant une structure à puits quantiques multiples disposée entre une couche conductrice n (1) et une couche conductrice p (5), ladite structure à puits quantiques multiples comprenant
- une pile de couches (3) constituée d'une pluralité de couches de puits quantiques (31) et d'au moins une couche barrière (32), une couche barrière (32) adjacente aux deux couches de puits quantiques (31) étant disposée entre chacune des deux couches de puits quantiques (31) successives ;
- une couche de finition côté n (2) adjacente à la pile de couches (3) et à la couche conductrice n (1) ; et
- une couche de finition côté p (4) disposée entre la pile de couches (3) et la couche conductrice p (4) et adjacente à la pile de couches (3), le premier composant du matériau semi-conducteur étant formé d'indium et la fraction molaire (x) du premier composant sur le matériau semi-conducteur étant
- supérieure, dans chacune des couches de puits quantiques (31), à celle de la couche de finition côté n (2), celle d'au moins une couche barrière (32) et celle de la couche de finition côté p (4) ; et
- supérieure, dans la couche de finition côté n (2), à celle de la couche conductrice n (1) et supérieure, dans la couche de finition côté p (4), à celle de la couche conductrice p (5), et
- la couche conductrice n (1) présentant une zone de délimitation côté p (11) adjacente à une zone de délimitation côté n (22) de la couche de finition côté n (2),
- la zone de délimitation côté p (11) de la couche conductrice n (1) et la zone de délimitation côté n (22) de la couche de finition côté n (2) étant dopées avec un dopant n,
- la couche de finition côté n (2) présentant une zone de délimitation côté p (21) directement adjacente à la pile de couches (3) et nominalement non dopée, et
- le dopant n étant présent dans la zone de délimitation côté p (11) de la couche conductrice n (1) et dans la zone de délimitation côté n (22) de la couche de finition côté n (2) à une concentration supérieure ou égale à 5 x 10¹⁸ atomes/cm³.

2. Corps semi-conducteur optoélectronique selon la revendication 1, la fraction molaire (x) du premier composant sur le matériau semi-conducteur dans au moins une couche barrière (32) étant au moins égale à celle de la couche de finition côté n (2).

3. Corps semi-conducteur optoélectronique selon l'une des revendications précédentes, la fraction molaire (x) du premier composant sur le matériau semi-conducteur dans au moins une couche barrière (32) étant au moins égale à celle de la couche de finition côté p (4).

4. Corps semi-conducteur optoélectronique selon l'une des revendications précédentes, la fraction molaire (x) du premier composant par rapport au matériau semi-conducteur dans la couche de finition côté n (2), dans au moins une couche barrière (32) et dans la couche de finition côté p (4) étant identique.

5. Corps semi-conducteur optoélectronique comprenant un matériau semi-conducteur comprenant un premier composant et un second composant différent du premier, et présentant une structure à puits quantique unique disposée entre une couche conductrice n (1) et une couche conductrice p (5), ladite structure à puits quantique unique comprenant
- une seule couche de puits quantique (31) ;
- une couche de finition côté n (2) adjacente à la couche de puits quantique (31) et à la couche conductrice n (1) ; et
- une couche de finition côté p (4) disposée entre la couche de puits quantique (3) et la couche conductrice p (4) et adjacente à ladite couche de puits quantique (31),
le premier composant du matériau semi-conducteur étant formé d'indium, et la fraction molaire (x) du premier composant sur le matériau semi-conducteur
- de la couche à puits quantique (31) étant supérieure à celle de la couche de finition côté n (2) et de la couche de finition côté p (4) ; et
- supérieure, dans la couche de finition côté n (2), à celle de la couche conductrice n (1) et supérieure, dans la couche de finition côté p (4), à celle de la couche conductrice p (5), et
- la couche conductrice n (1) présentant une zone de délimitation côté p (11) adjacente à une zone de délimitation côté n (22) de la couche de finition côté n (2),
- la zone de délimitation côté p (11) de la couche conductrice n (1) et la zone de délimitation côté n (22) de la couche de finition côté n (2) étant dopées avec un dopant n,
- la couche de finition côté n (2) présentant une zone de délimitation côté p (21) directement adjacente à la seule couche de puits quantique (31) et nominalement non dopée, et
- le dopant n étant présent dans la zone de délimitation côté p (11) de la couche conductrice n (1) et dans la zone de délimitation côté n (22) de la couche de finition côté n (2) à une concentration supérieure ou égale à 5 x 10¹⁸ atomes/cm³.

6. Corps semi-conducteur optoélectronique selon l'une des revendications précédentes, la couche de finition côté n (2) présentant une épaisseur (d) supérieure ou égale à 10 nm, en particulier supérieure ou égale à 50 nm.

7. Corps semi-conducteur optoélectronique selon l'une des revendications précédentes, **caractérisé en ce que** la zone de délimitation côté p (21) de la couche de finition côté n (2) présentant une épaisseur de couche supérieure ou égale à 10 nm.

8. Corps semi-conducteur optoélectronique selon l'une des revendications précédentes, le second composant du matériau semi-conducteur comprenant de l'azote et au moins un matériau du groupe composé d'Al et Ga.

9. Corps semi-conducteur optoélectronique selon la revendication 8, le matériau semi-conducteur étant InₓAl_{y}Ga_{1-x-y}N avec 0 ≤ x ≤ 1, 0 ≤ y ≤ 1 et x+y ≤ 1, et le premier composant formé d'indium présentant une proportion x ≥ 0,05 dans la couche de finition côté n.

10. Corps semi-conducteur optoélectronique selon l'une des revendications précédentes, la couche conductrice n (1) étant exempte du premier composant du matériau semi-conducteur.

11. Corps semi-conducteur optoélectronique selon l'une des revendications précédentes, dans lequel la fraction molaire (x) du premier composant dans la couche de finition côté n (2) augmentant continuellement ou en plusieurs paliers dans la direction opposée à la couche conductrice côté n (1), en particulier dans la zone de délimitation côté n (22) de la couche de finition côté n (2) .
